# EUROPÄISCHE PATENTSCHRIFT

(11) **EP 4 657 084 B1**
(45) Veröffentlichungstag und Bekanntmachung des Hinweises auf die Patenterteilung: **02.09.2026**
(21) Anmeldenummer: 25177657.1
(22) Anmeldetag: 20.05.2025
(51) Int. Cl.: G01R 27/02, G01R 27/20, G01R 31/52, G01R 31/66

(54) **ELEKTRISCHE MESSANORDNUNG UND MESSVERFAHREN ZUR ERDANSCHLUSSÜBERWACHUNG FÜR EIN ISOLATIONSÜBERWACHUNGSGERÄT UND ISOLATIONSÜBERWACHUNGSGERÄT**
ELECTRICAL MEASURING ARRANGEMENT AND MEASURING METHOD FOR EARTH CONNECTION MONITORING FOR AN INSULATION MONITORING DEVICE AND INSULATION MONITORING DEVICE
DISPOSITIF DE MESURE ÉLECTRIQUE ET PROCÉDÉ DE MESURE POUR LA SURVEILLANCE DE RACCORDEMENT À LA TERRE POUR UN APPAREIL DE SURVEILLANCE D'ISOLATION ET APPAREIL DE SURVEILLANCE D'ISOLATION

(30) Priorität: 29.05.2024 DE 102024115040
(43) Veröffentlichungstag der Anmeldung: 03.12.2025
(73) Patentinhaber: Bender GmbH & Co. KG, 35305 Grünberg (DE)
(72) Erfinder: Reitz, Julian, 35305 Grünberg (DE); Schäfer, Oliver, 35305 Grünberg (DE); Weber, Simon, 63667 Nidda (DE)
(74) Vertreter: advotec.

(56) Entgegenhaltungen:
- EP-A1- 4 242 674
- EP-A1- 4 435 443
- CN-A- 117 441 107

## Beschreibung

Die Erfindung betrifft eine elektrische Messanordnung und ein Messverfahren zur Erdanschlussüberwachung für ein Isolationsüberwachungsgerät, welches an mindestens einen aktiven Leiter eines ungeerdeten Stromversorgungsystems und an einen Erdanschlusspunkt einer elektrischen Anlage angeschlossen ist.

Weiter betrifft die Erfindung ein Isolationsüberwachungsgerät, welches zur Überwachung eines Isolationswiderstands eines ungeerdeten Stromversorgungsystems an mindestens einen aktiven Leiter des ungeerdeten Stromversorgungsystems und an einen Erdanschlusspunkt einer elektrischen Anlage anschließbar ist.

Bei erhöhten Anforderungen an die Betriebs-, Brand-und Berührungssicherheit elektrischer Anlagen kommt die Netzform eines ungeerdeten Stromversorgungssystems zum Einsatz, die auch als isoliertes Netz (frz. "Isolé Terre"-IT) oder als IT-Stromversorgungssystem bezeichnet wird. Bei dieser Art des Stromversorgungssystems sind die aktiven Teile des Stromversorgungssystems von dem Erdpotential - gegen Erde - getrennt.

Die Körper der angeschlossenen elektrischen Verbraucher sind einzeln oder gemeinsam geerdet. Der Vorteil dieser Netze liegt darin, dass bei einem ersten Isolationsfehler die Funktion der angeschlossenen elektrischen Verbraucher nicht beeinträchtigt wird und somit trotz des fehlerhaften Zustands der Isolierung ein Weiterbetrieb möglich ist, da sich wegen des im Idealfall unendlich großen elektrischen Widerstands (Isolationswiderstand) zwischen einem aktiven Leiter des Netzes und Erdpotential kein geschlossener Stromkreis ausbilden kann.

Der Isolationswiderstand des ungeerdeten Stromversorgungssystems muss daher ständig überwacht werden, da durch einen möglichen weiteren Fehler (Isolationsfehler) an einem anderen aktiven Leiter eine Fehlerschleife entstünde und der dabei fließende Fehlerstrom in Verbindung mit einer Überstromschutzeinrichtung eine Abschaltung der Anlage mit Betriebsstillstand zur Folge hätte.

Zur Überwachung des Isolationswiderstands werden Isolationsüberwachungsgeräte (IMDs) eingesetzt. Aus dem Stand der Technik bekannte aktiv arbeitende Isolationsüberwachungsgeräte werden zwischen den aktiven Leitern einerseits und Erde andererseits angeschlossen und überlagern dem Netz eine vorzugsweise impulsförmige Messspannung (Messpulse). Bei Auftreten eines Isolationsfehlers schließt sich der Messkreis zwischen Netz und Erde über den Isolationsfehler, sodass sich ein dem Isolationsfehler proportionaler Messstrom einstellt. Dieser Messstrom verursacht an einem Messwiderstand in dem Isolationsüberwachungsgerät einen entsprechenden Spannungsabfall, der von einer Elektronik ausgewertet wird und bei Überschreiten eines voreinstellbaren Grenzwertes zu einer Alarmmeldung führt.

Daneben existieren passiv arbeitende Überwachungsgeräte (Erdschlusswächter), die mit Spannungsmessverfahren wie der 3-Voltmeter-Methode allerdings nur unsymmetrische Isolationsfehler erkennen können.

In allen Fällen der Isolationsüberwachung muss durch minimale Übergangswiderstände die Kontaktierung des Erdanschlusses über die Erdanschlussklemme des Isolationsüberwachungsgerätes mit dem Erdanschlusspunkt (Erdpotential) bei der Bestimmung des Isolationswiderstands sichergestellt sein. Um eine einwandfreie Funktion des Isolationsüberwachungsgerätes zu gewährleisten, bedarf es daher einer permanenten Überwachung der niederohmigen Anbindung (Erdverbindung) des Isolationsüberwachungsgerätes an das Erdpotential, um bei einer Verschlechterung oder vollständigem Verlust der Erdverbindung eine Meldung ausgeben zu können.

Eine Vorschrift zur Erdanschlussüberwachung ist beispielsweise der Norm DIN EN 61557-8:2015, Anhang Kapitel A.4.2.2 "Prüfung der Funktion einer Anzeige der Unterbrechung der Verbindung zu dem überwachten System" zu entnehmen. Demgemäß ist die Anzeige für den Verlust der Erdverbindung und den Verlust der Verbindung zum zu überwachenden Netz zu prüfen. Eine Meldung muss erfolgen, wenn der Erdanschluss oder der Netzanschluss oder beide Anschlüsse zusammen unterbrochen werden.

Dem Stand der Technik gemäß sind auf dem Markt Isolationsüberwachungsgeräte verfügbar, die durch ihre einpolige Ankopplung an das Erdpotential zwar in der Lage sind, ein Absinken des Isolationswiderstands oder eine Unterbrechung der Erdverbindung festzustellen, nicht aber ermitteln können, ob der von dem Isolationsüberwachungsgerät gemessene Widerstandswert der tatsächliche Isolationswiderstand des ungeerdeten Stromversorgungssystems gegen Erde ist oder auf eine fehlerhafte Erdverbindung zurückzuführen ist, da es sich in dem Messkreis um eine Reihenschaltung der beteiligten Widerstände handelt.

Aus dem Stand der Technik sind weiter Isolationsüberwachungsgeräte bekannt, die über eine zweite Erdanschlussklemme verfügen und mittels einer passiven Rückmessung der von dem Isolationsüberwachungsgerät eingespeisten Messspannung eine Unterbrechung der Erdverbindung feststellen.

Allerdings wird bei sämtlichen bekannten Isolationsüberwachungsgeräten nur binär in einer "harten" 1/0-Entscheidung zwischen einem guten und einem schlechten Zustand der Erdverbindung unterschieden - eine quantitative Bestimmung des Erdungswiderstands der Erdverbindung ist nicht vorgesehen, sodass die Auslösung einer Isolationswiderstands-Alarmmeldung stets mit einer Fehlerwahrscheinlichkeit behaftet ist.

Ebenso ist bei aktiven Isolationsüberwachungsgeräten eine von der Messspannung des Isolationsüberwachungsgerätes unabhängige Bestimmung des Erdungswiderstands nicht bekannt. CN117441107 offenbart ein Isolationsüberwachungsgerät.

Der vorliegenden Erfindung liegt somit die Aufgabe zugrunde, eine elektrische Messanordnung und ein Verfahren zu konzipieren, mit welchen eine zuverlässigere Überwachung der Erdverbindung sowohl für aktiv als auch für passiv arbeitende Isolationsüberwachungsgeräte und bei aktiver wie bei inaktiver Messspannung möglich ist.

Diese Aufgabe wird gelöst durch eine aktive Schleifenmesseinrichtung, welche zwischen einer Erdanschlussklemme des Isolationsüberwachungsgerätes und dem Erdanschlusspunkt anschließbar ist und eine eigenständige Anregungs-Spannungsquelle aufweist zur quantitativen Bestimmung eines Erdungswiderstands der Erdverbindung zwischen dem Isolationsüberwachungsgerät und dem Erdanschlusspunkt.

Der Grundgedanke der vorliegenden Erfindung beruht darauf, den Erdungswiderstand der Erdverbindung durch eine eigenständige, von der Messspannung des Isolationsüberwachungsgerätes unabhängige Messanordnung zu bestimmen. Dazu ist die Messanordnung als aktive Schleifenmesseinrichtung mit einer eigenständigen Anregungs-Spannungsquelle ausgeführt und somit in der Lage, auch bei inaktivem Messpuls des Isolationsüberwachungsgerätes oder bei passiven Isolationsüberwachungsgeräten die Erdverbindung sicher überwachen zu können.

Die Messanordnung ist mit der Erdanschlussklemme des Isolationsüberwachungsgerätes einerseits und dem Erdanschlusspunkt (PE) andererseits verbunden und ermöglicht mit einer "weichen" Entscheidung eine quantitative Bestimmung des Erdungswiderstands der Erdverbindung zwischen dem Isolationsüberwachungsgerät und dem Erdanschlusspunkt. Auf diese Weise kann die Qualität (Durchgängigkeit) der Erdverbindung abgestuft beurteilt werden und somit ist gewährleistet, dass das Isolationsüberwachungsgerät insbesondere bei Alarmschwellen im niederohmigen Messbereich zuverlässige Ergebnisse liefert.

Auch auf etwaige Störsignale kann durch Frequenz- oder Signalformanpassung damit einfacher und unabhängig der Messtechnik der eigentlichen Isolationsüberwachung reagiert werden. Ebenso vorteilhaft ist, dass durch die Quantifizierung des Erdungswiderstands die Möglichkeit besteht, die Alarmschwellen für die Erdanschlussüberwachung auf die Kundenbedürfnisse anpassen zu können.

Zudem wird bei der Entwicklung von Isolationsüberwachungsgeräten die oftmals auftretende Schwierigkeit überwunden, dass aufgrund externer Faktoren das Schaltungsbezugspotential mit dem Erdpotential gleichgesetzt werden muss.

In weiterer Ausgestaltung weist die Schleifenmesseinrichtung eine Reihenschaltung auf, umfassend die Anregungs-Spannungsquelle zur Überlagerung eines Anregungssignals, einen Schleifen-Messwiderstand, einen Schleifen-Ankoppelwiderstand, eine Mess- und Filterschaltung, die zwischen dem Schleifen-Messwiderstand und dem Schleifen-Ankoppelwiderstand eine Schleifen-Messspannung erfasst, einen Mikrocontroller, der die Schleifen-Messspannung zur Berechnung des Erdungswiderstands auswertet, und eine Kontrollerde-Anschlussklemme zum Anschluss des Schleifen-Ankoppelwiderstands an den Erdanschlusspunkt.

Die aktive Schleifenmesseinrichtung besteht aus einer Reihenschaltung zwischen der Erdanschlussklemme des Isolationsüberwachungsgerätes und einer Kontrollerde-Anschlussklemme, die mit dem Erdanschlusspunkt verbunden wird.

Als funktionale Elemente umfasst die Reihenschaltung die Anregungs-Spannungsquelle, einen Schleifen-Messwiderstand und einen Schleifen-Ankoppelwiderstand, eine Mess- und Filterschaltung sowie einen Mikrocontroller.

Da sowohl ausgehend von der Erdanschlussklemme des Isolationsüberwachungsgerätes als auch von der erfindungsgemäß vorgesehenen Kontrollerde-Anschlussklemme der Schleifenmesseinrichtung Leitungs-und Kontaktwiderstände (Übergangswiderstände) vorhanden sind, bildet sich über den Erdanschlusspunkt und über die Kontrollerde-Anschlussklemme eine widerstandsbehaftete Stromschleife aus. Der darin fließende Strom wird durch die von der Anregungs-Spannungsquelle überlagerte Anregungsspannung unabhängig von der Netzspannung und von der Messspannung des Isolationsüberwachungsgerätes getrieben. In Kenntnis des Schleifen-Messwiderstands und des Schleifen-Ankoppelwiderstands sowie mit der von der Mess- und Filterschaltung erfassten Schleifen-Messspannung berechnet der Mikrocontroller den Erdungswiderstand der Erdverbindung zwischen dem Isolationsüberwachungsgerät und dem Erdanschlusspunkt.

Bevorzugt ist die Anregungsspannung eine bipolare Rechteckspannung mit einer Grundfrequenz im Bereich von 0.1 Hz bis 10 Hz und einem Spannungshub kleiner als 10 V.

Der Frequenzbereich von 0.1 Hz bis 10 Hz kann mit hinreichender Genauigkeit in der Mess- und Filterschaltung mit Tiefpass-Charakter separiert werden. Im Falle massiver Störungen durch externe Störquellen, wie beispielsweise Frequenzumrichtern, wäre es optimierend möglich, die Anregungsspannung der Anregungs-Spannungsquelle über den Mikrocontroller durch eine Softwareänderung auf ein Sinusgemisch aus mehreren Frequenzen umzustellen. Durch eine gezielte Frequenzanalyse mittels DFT/FFT können dann nur ungestörte Signalbestandteile zur weiteren Analyse herangezogen werden.

Durch den Einfluss der zu der Anregungs-Spannungsquelle unsynchronisierten Messspannungsquelle des Isolationsüberwachungsgerätes oder aufgrund externer Quellen kann es auf der Erdverbindung zu Fremdgleichströmen kommen, welche das erfindungsgemäße Messverfahren stören könnten. Um dagegen robust zu werden, wird der Spannungshub der Anregungsspannung und der Spannungshub der Schleifen-Messspannung anstelle der absoluten Pegel zur Berechnung des Erdungswiderstands verwendet.

Mit Vorteil ist zwischen die Erdanschlussklemme des Isolationsüberwachungsgerätes und die Kontrollerde-Anschlussklemme der Schleifenmesseinrichtung eine TVS-Diode geschaltet.

Durch die Anbringung der TVS-Diode (Transient Voltage Suppressor oder Suppressordiode) mit einer Durchbruchspannung kleiner 10 V zwischen die Erdanschlussklemme und die Kontrollerde-Anschlussklemme ist die Verbindung über die Kontrollerde-Anschlussklemme in der Lage, als redundante Erdverbindung zu wirken. Ebenso begrenzt die TVS-Diode die Fremdgleichspannung zwecks Schaltungsschutz. Ein Ansprechen der TVS-Diode ist durch die Mess- und Filterschaltung in Verbindung mit dem Mikrocontroller erkennbar und kann als unzulässiger Zustand bewertet werden.

Des Weiteren wird ein erfindungsgemäßes Isolationsüberwachungsgerät beansprucht, bei dem ein die Erfindung betreffendes bekanntes Isolationsüberwachungsgerät mit der erfindungsgemäßen elektrischen Messanordnung zur Erdanschlussüberwachung erweitert wird.

Neben einer Ausführung der erfindungsgemäßen elektrischen Messanordnung als separate, von einem Isolationsüberwachungsgerät getrennte bauliche Einheit ist somit auch die Integration in ein Isolationsüberwachungsgerät in Form einer gemeinsamen baulichen Einheit möglich.

Die Funktion der zuvor beschriebenen erfindungsgemäßen elektrischen Messanordnung beruht auf dem in dem unabhängigen Verfahrensanspruch beschriebenen Messverfahren zur Erdanschlussüberwachung für ein Isolationsüberwachungsgerät. Insoweit treffen die vorgenannten technischen Wirkungen und daraus entstehenden verfahrenstechnischen Vorteile auch auf die Verfahrensmerkmale zu.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:
- **Fig.** 1:: eine Erdanschlussüberwachung nach dem Stand der Technik und
- Fig. 2:: eine Erdanschlussüberwachung mit Isolationsüberwachungsgerät und einer erfindungsgemäßen elektrischen Messanordnung.

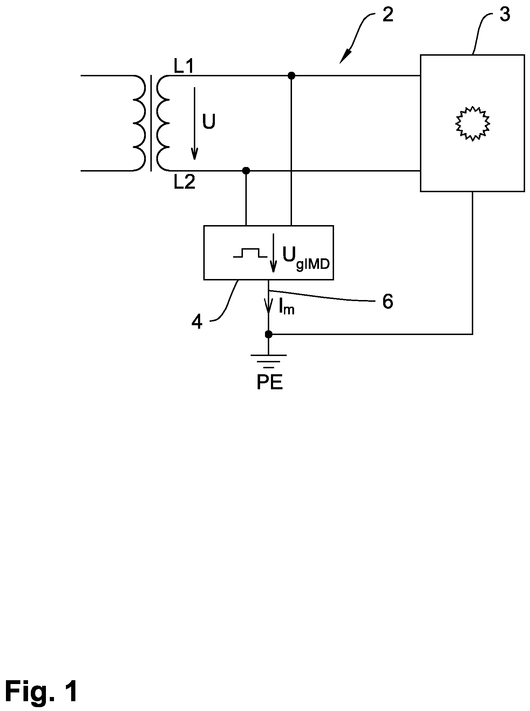

**Fig.1** zeigt eine Erdanschlussüberwachung nach dem Stand der Technik mit einem Isolationsüberwachungsgerät 4, welches an die aktiven Leiter L1, L2 eines ungeerdeten Stromversorgungsystems 2 und über eine Erdverbindung 6 an einen Erdanschlusspunkt PE einer elektrischen Anlage 3 angeschlossen ist.

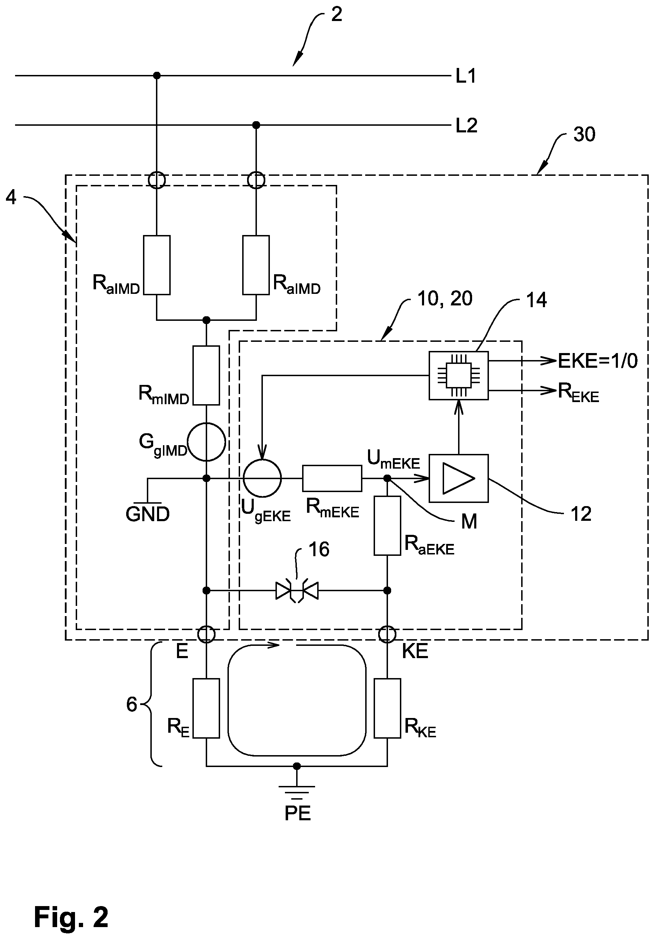

In **Fig. 2** ist eine Erdanschlussüberwachung mit einem an das ungeerdete Stromversorgungsystem 2 angeschlossenen Isolationsüberwachungsgerät 4 und einer erfindungsgemäßen elektrischen Messanordnung 10 dargestellt.

Das Isolationsüberwachungsgerät 4 ist über Ankoppelwiderstände R_{aIMD} an die aktiven Leiter L1, L2 des ungeerdeten Stromversorgungsystems 2 angekoppelt und umfasst einen Messspanungsgenerator U_{gImD} zur Einspeisung einer Messspannung U_{gIMD} sowie einen Messwiderstand R_{mIMD} zur Messung eines dem Isolationswiderstand entsprechenden Messstroms Iₘ. Über die Erdanschlussklemme E ist das Isolationsüberwachungsgerät 4 mit dem Bezugspotential GND an den Erdanschlusspunkt PE angeschlossen, um die Erdverbindung 6 herzustellen.

Zwischen die Erdanschlussklemme E des Isolationsüberwachungsgerätes 4 und einer Kontrollerde-Anschlussklemme KE ist die erfindungsgemäße elektrische Messanordnung 10 angeordnet. Die elektrische Messanordnung 10 ist als aktive Schleifenmesseinrichtung 20 in Form einer Reihenschaltung ausgebildet. Die Reihenschaltung umfasst eine Anregungs-Spannungsquelle U_{gEKE}, welche eine Anregungsspannung U_{gEKE} erzeugt. Die Anregungsspannung U_{gEKE} treibt einen Strom in einer Stromschleife über die Erdanschlussklemme E und die Kontrollerde-Anschlussklemme KE mit den Übergangswiderständen R_{E} und R_{KE}.

Infolge dessen wird an einem Schleifen-Messwiderstand R_{mEKE} ein Spannungsabfall bewirkt, der als Schleifen-Messspannung U_{mEKE} erfasst und zur Messung des Erdungswiderstands R_{EKE} herangezogen wird.

Der Messpunkt M der Schleifen-Messspannung U_{mEKE} ist mit der Kontrollerde-Anschlussklemme KE über einen Schleifen-Ankoppelwiderstand R_{aEKE} verbunden.

Der aus den Übergangswiderständen R_{E}, R_{KE} in der sich über die Erdanschlussklemme E, den Erdanschlusspunkt PE und die Kontrollerde-Anschlussklemme KE ausgebildeten Stromschleife zusammengesetzte Erdungswiderstand R_{EKE} lässt sich mit den für lineare Netzwerke geltenden Strom -/Spannungsbeziehungen (Maschen- und Knotenpunktsregel sowie ohmsches Gesetz) berechnen zu ${R}_{EKE} = {R}_{E} + {R}_{KE} = \frac{{R}_{mEKE}}{\left(\frac{Δ {U}_{gEKE}}{Δ {U}_{mEKE}}-1\right)} - {R}_{aEKE} .$

Um das Verfahren störresistenter zu gestalten, werden in die Berechnung der Spannungshub Δ der Anregungsspannung U_{gEKE} und der Spannungshub Δ der Schleifen-Messspannung U_{mEKE} anstelle der absoluten Werte einbezogen.

Zur Erfassung der Schleifen-Messspannung U_{mEKE} an dem Messpunkt M ist eine elektronische Mess- und Filterschaltung 12 mit Tiefpasswirkung und etwaigen Stufen zur Pegelanpassung vorhanden.

Die Mess- und Filterschaltung 12 leitet das Messergebnis an einen Mikrocontroller 14 weiter, der die Schleifen-Messspannung U_{mEKE} zur Berechnung des Erdungswiderstands R_{EKE} gemäß der oben angegebenen Gleichung auswertet.

Der Mikrocontroller 14 besitzt eine Auswertealgorithmik, die den Erdungswiderstands R_{EKE} als Widerstandswert der Schleife im Bereich R_{EKE} = 0...2 kΩ quantifiziert. Dazu kann Schwellwert R_{EKEth} per Software eingestellt werden. Darüber hinaus kann der Mikrocontroller 14 auch andere Aufgaben als jene der Schleifenmessung übernehmen, z.B. die Messtechnik der Isolationsüberwachung in dem Isolationsüberwachungsgerät 4 oder eine HMI-Ansteuerung.

In Fig. 2 ist optional eine TVS-Diode 16 in einem Leitungszweig zwischen die Erdanschlussklemme E des Isolationsüberwachungsgerätes 4 und die Kontrollerde-Anschlussklemme KE eingefügt, um eine redundante Erdverbindung bereitzustellen.

## Patentansprüche

1. Elektrische Messanordnung (10) zur Erdanschlussüberwachung für ein Isolationsüberwachungsgerät (4), welches an mindestens einen aktiven Leiter (L1, L2) eines ungeerdeten Stromversorgungsystems (2) und an einen Erdanschlusspunkt (PE) einer elektrischen Anlage (3) angeschlossen ist,
**gekennzeichnet durch**
eine aktive Schleifenmesseinrichtung (20), welche zwischen einer Erdanschlussklemme (E) des Isolationsüberwachungsgerätes (4) und dem Erdanschlusspunkt (PE) anschließbar ist und eine eigenständige Anregungs-Spannungsquelle (U_{gEKE}) aufweist zur quantitativen Bestimmung eines Erdungswiderstands (R_{EKE}) der Erdverbindung (6) zwischen dem Isolationsüberwachungsgerät (4) und dem Erdanschlusspunkt (PE).

2. Elektrische Messanordnung (10) nach Anspruch 1,
**dadurch gekennzeichnet,**
**dass** die Schleifenmesseinrichtung (20) eine Reihenschaltung aufweist umfassend
die Anregungs-Spannungsquelle (U_{gEKE}) zur Überlagerung einer Anregungsspannung (U_{gEKE}),
einen Schleifen-Messwiderstand (R_{mEKE}),
einen Schleifen-Ankoppelwiderstand (R_{aEKE}),
eine Mess- und Filterschaltung (12), die zwischen dem Schleifen-Messwiderstand (R_{mEKE}) und dem Schleifen-Ankoppelwiderstand (R_{aEKE}) eine Schleifen-Messspannung (U_{mEKE}) erfasst,
einen Mikrocontroller (14), der die Schleifen-Messspannung (U_{mEKE}) zur Berechnung des Erdungswiderstands (R_{EKE}) auswertet, und
eine Kontrollerde-Anschlussklemme (KE) zum Anschluss des Schleifen-Ankoppelwiderstands (R_{aEKE}) an den Erdanschlusspunkt (PE).

3. Elektrische Messanordnung (10) nach Anspruch 2,
**dadurch gekennzeichnet,**
**dass** die Anregungsspannung (U_{gEKE}) eine bipolare Rechteckspannung mit einer Grundfrequenz im Bereich von 0.1 Hz bis 10 Hz und einem Spannungshub kleiner als 10 V ist.

4. Elektrische Messanordnung (10) nach Anspruch 2 oder 3,
**dadurch gekennzeichnet,**
**dass** zwischen die Erdanschlussklemme (E) des Isolationsüberwachungsgerätes (4) und die Kontrollerde-Anschlussklemme (KE) der Schleifenmesseinrichtung eine TVS-Diode (16) geschaltet ist.

5. Isolationsüberwachungsgerät, (30) welches zur Überwachung eines Isolationswiderstands eines ungeerdeten Stromversorgungsystems (2) an mindestens einen aktiven Leiter (L1, L2) des ungeerdeten Stromversorgungsystems (2) und an einen Erdanschlusspunkt (PE) einer elektrischen Anlage (3) anschließbar ist,
**gekennzeichnet durch**
eine elektrische Messanordnung (10) nach einem der Ansprüche 1 bis 4.

6. Messverfahren zur Erdanschlussüberwachung für ein Isolationsüberwachungsgerät (4), welches an mindestens einen aktiven Leiter (L1, L2) eines ungeerdeten Stromversorgungsystems (2) und an einen Erdanschlusspunkt (PE) einer elektrischen Anlage (3) angeschlossen ist,
**gekennzeichnet durch**
ein quantitatives Bestimmen eines Erdungswiderstands (R_{EKE}) der Erdverbindung (6) zwischen dem Isolationsüberwachungsgerät (4) und dem Erdanschlusspunkt (PE) mittels einer aktiven Schleifenmesseinrichtung (20), welche zwischen einer Erdanschlussklemme (E) des Isolationsüberwachungsgerätes (4) und dem Erdanschlusspunkt (PE) anschließbar ist und eine eigenständige Anregungs-Spannungsquelle (U_{gEKE}) aufweist.

7. Messverfahren nach Anspruch 6,
wobei das quantitative Bestimmen des Erdungswiderstands (R_{EKE}) in der Schleifenmesseinrichtung (20) erfolgt, welche eine Reihenschaltung aufweist umfassend
die Anregungs-Spannungsquelle (U_{gEKE}), die mit der Erdanschlussklemme (E) des Isolationsüberwachungsgerätes (4) verbindbar ist, einen Schleifen-Messwiderstand (R_{mEKE}),
einen Schleifen-Ankoppelwiderstand (R_{aEKE}),
eine Mess- und Filterschaltung (12) mit einem Spannungsabgriff zwischen dem Schleifen-Messwiderstand (R_{mEKE}) und dem Schleifen-Ankoppelwiderstand (R_{aEKE}),
einen Mikrocontroller (14) und
einen Kontrollerde-Anschlussklemme (KE) zum Anschluss des Schleifen-Ankoppelwiderstands (R_{aEKE}) an den Erdanschlusspunkt (PE),
**gekennzeichnet durch**
Überlagern einer Anregungsspannung (U_{gEKE}) mittels der Anregungs-Spannungsquelle (U_{gEKE}) ,
Erfassen und Filtern einer Schleifen-Messspannung (U_{mEKE}) mittels der Mess- und Filterschaltung (12),
Auswerten der Schleifen-Messspannung (U_{mEKE}) und Berechnen des Erdungswiderstands (R_{EKE}) mittels des Mikrocontrollers (14).

8. Messverfahren nach Anspruch 7,
**dadurch gekennzeichnet,**
**dass** als Anregungsspannung (U_{gEKE}) eine bipolare Rechteckspannung mit einer Grundfrequenz im Bereich von 0.1 Hz bis 10 Hz und einem Spannungshub kleiner als 10 V überlagert wird.

9. Messverfahren nach Anspruch 8,
**dadurch gekennzeichnet,**
**dass** der Spannungshub der Anregungsspannung (U_{gEKE}) und der Schleifen-Messspannung (U_{mEKE}) in der Mess- und Filterschaltung (12) und dem Mikrocontroller (14) zum Berechnen des Erdungswiderstands (R_{EKE}) herangezogen wird.

## Claims

1. An electric measurement arrangement (10) for a ground connection monitoring system for an insulation monitoring device (4), which is connected to at least one active conductor (L1, L2) of an ungrounded power supply system (2) and to a ground terminal (PE) of an electric installation (3),
**characterized by**
an active loop measurement device (20), which is connectable between a ground-connection clamp (E) of the insulation monitoring device (4) and the ground terminal (PE) and has an independent excitation voltage source (U_{gEKE}) for quantitatively determining a ground resistance (R_{EKE}) of the ground connection (6) between the insulation monitoring device (4) and the ground terminal (PE).

2. The electric measurement arrangement (10) according to claim 1,
**characterized in that**
the loop measurement device (20) has a series connection comprising the excitation voltage source (U_{gEKE}) for superimposing an excitation voltage (U_{gEKE}),
a loop measuring resistance (R_{mEKE}),
a loop coupling resistance (R_{aEKE}),
a test and filter circuit (12) which detects a loop measuring voltage (U_{mEKE}) between the loop measuring resistance (R_{mEKE}) and the loop coupling resistance (R_{aEKE}),
a microcontroller (14) which evaluates the loop measuring voltage (U_{mEKE}) for computing the ground resistance (R_{EKE}), and
a control-ground connection clamp (KE) for connecting the loop couple resistance (R_{aEKE}) to the ground terminal (PE).

3. The electric measurement arrangement (10) according to claim 2,
**characterized in that**
the excitation voltage (U_{gEKE}) is a bipolar square wave voltage having a base frequency ranging from 0.1 Hz to 10 Hz and a voltage change less than 10 V.

4. The electric measurement arrangement (10) according to claim 2 or 3,
**characterized in that**
a TVS diode (16) is switched between the ground-connection clamp (E) of the insulation monitoring device (4) and the control-ground connection clamp (KE) of the loop measuring device.

5. An insulation monitoring device (30) which is connectable to at least one active conductor (L1, L2) of the ungrounded power supply system (2) and to a ground terminal (PE) of an electric installation (3) in order to monitor an insulation resistance of an ungrounded power supply system (2),
**characterized by**
an electric measuring arrangement (10) according to any one of the claims 1 to 4.

6. A measuring method for monitoring a ground connection for an insulation monitoring device (4), which is connected to at least one active conductor (L1, L2) of an ungrounded power supply system (2) and a ground terminal (PE) of an electric installation (3),
**characterized by**
quantitatively determining a ground resistance (R_{EKE}) of the ground connection (6) between the insulation monitoring device (4) and the ground terminal (PE) by means of an active loop measuring device (20), which is connectable between a ground-connection clamp (E) of the insulation monitoring device (4) and the ground terminal (PE) and has an independent excitation voltage source (U_{gEKE}).

7. A measuring method according to claim 6,
wherein the ground resistance (R_{EKE}) is quantitatively determined in the loop measuring device (20), which has a series connection comprising the excitation voltage source (U_{gEKE}), which is connectable to the ground-connection clamp (E) of the insulation monitoring device (4), a loop measuring resistance (R_{mEKE}),
a loop coupling resistance (R_{aEKE}),
a test and filter circuit (12) having a voltage tap between the loop measuring resistance (R_{mEKE}) and the loop coupling resistance (R_{aEKE}), a microcontroller (14), and
a control-ground connection clamp (KE) for connecting the loop coupling resistance (R_{aEKE}) to the ground terminal (PE),
**characterized by**
superposing an excitation voltage (U_{gEKE}) by means of the excitation voltage source (U_{gEKE}),
detecting and filtering a loop measuring voltage (U_{mEKE}) by means of the test and filter circuit (12),
evaluating the loop measuring voltage (U_{mEKE}) and computing the ground resistance (R_{EKE}) by means of the microcontroller (14).

8. The measuring method according to claim 7,
**characterized in that**
an a bipolar square wave voltage having a base frequency ranging from 0.1 Hz to 10 Hz and a voltage change less than 10 V is superimposed as excitation voltage (U_{gEKE}).

9. The measuring method according to claim 8,
**characterized in that**
the voltage change of the excitation voltage (U_{gEKE}) and the loop measuring resistance (U_{mEKE}) in the test and filter circuit (12) and the microcontroller (14) is used to compute the ground resistance (R_{EKE}).

## Revendications

1. Dispositif de mesure (10) électrique pour un système de surveillance de bornes de terre destiné à un dispositif (4) de surveillance d'isolement, qui est connecté à au moins un conducteur actif (L1, L2) d'un système (2) d'alimentation en courant non mis à la terre et à une borne de terre (PE) d'une installation (3) électrique,
**caractérisé par**
un dispositif actif (20) de mesure de boucle, qui peut être connecté entre une mâchoire (E) de borne de terre du dispositif (4) de surveillance d'isolement et la borne de terre (PE) et qui a une source (U_{gEKE}) indépendante de tension d'excitation pour déterminer quantitativement une résistance de terre (R_{EKE}) de la connexion de terre (6) entre le dispositif (4) de surveillance d'isolement et la borne de terre (PE).

2. Dispositif de mesure (10) électrique selon la revendication 1,
**caractérisé en ce que**
le dispositif (20) de mesure de boucle a un montage en série comprenant
la source (U_{gEKE}) de tension d'excitation destinée à superposer une tension d'excitation (U_{gEKE}),
une résistance (R_{mEKE}) de mesure de boucle,
une résistance de couplage de boucle (R_{aEKE}),
un montage d'essai (12) et un circuit de filtrage (12) qui détecte une tension (U_{mEKE}) de mesure de boucle entre la résistance (R_{mEKE}) de mesure de boucle et la résistance (R_{aEKE}) de couplage de boucle,
un microcontrôleur (14) qui évalue la tension (U_{mEKE}) de mesure de boucle pour calculer la résistance de terre (R_{EKE}), et
une borne de raccordement (KE) d'une terre de contrôle destinée à connecter la résistance (R_{aEKE}) de couplage de boucle à la borne de terre (PE).

3. Dispositif de mesure (10) électrique selon la revendication 2,
**caractérisé en ce que**
la tension d'excitation (U_{gEKE}) est une tension carrée bipolaire ayant une fréquence fondamentale comprise entre 0,1 Hz et 10 Hz et une variation brusque de tension inférieure à 10 V.

4. Dispositif de mesure (10) électrique selon la revendication 2 ou la revendication 3,
**caractérisé en ce**
**qu'**une diode TVS (16) est commutée entre la mâchoire (E) de borne de terre du dispositif (4) de surveillance d'isolement et la borne (KE) de raccordement d'une terre de contrôle du dispositif de mesure de boucle.

5. Dispositif (30) de surveillance d'isolement pouvant être connecté à au moins un conducteur actif (L1, L2) du système (2) d'alimentation en courant non mis à la terre et à une borne de terre (PE) d'une installation (3) électrique afin de surveiller une résistance d'isolement d'un système (2) d'alimentation en courant non mis à la terre,
**caractérisé par**
un dispositif de mesure (10) électrique selon l'une quelconque des revendications 1 à 4.

6. Procédé de mesure destiné à surveiller une borne de terre pour un dispositif (4) de surveillance d'isolement, qui est connecté à au moins un conducteur actif (L1, L2) d'un système (2) d'alimentation en courant non mis à la terre et à une borne de terre (PE) d'une installation électrique (3),
**caractérisé par**
la détermination quantitative d'une résistance de terre (R_{EKE}) de la connexion de terre (6) entre le dispositif (4) de surveillance d'isolement et la borne de terre (PE) au moyen d'un dispositif actif (20) de mesure de boucle, qui peut être connecté entre une mâchoire (E) de borne de terre du dispositif (4) de surveillance d'isolement et la borne de terre (PE) et qui a une source (U_{gEKE}) de tension d'excitation indépendante.

7. Procédé de mesure selon la revendication 6,
dans lequel la résistance de terre (R_{EKE}) est déterminée quantitativement dans le dispositif (20) de mesure de boucle qui a un montage en série comprenant
la source (U_{gEKE}) de tension d'excitation qui peut être connectée à la mâchoire (E) de borne de terre du dispositif (4) de surveillance d'isolement,
une résistance (R_{mEKE}) de mesure de boucle,
une résistance (R_{aEKE}) de couplage de boucle,
un montage d'essai (12) et un circuit de filtrage (12) ayant une prise de tension entre la résistance (R_{mEKE}) de mesure de boucle et la résistance (R_{aEKE}) de couplage de boucle,
un microcontrôleur (14), et
une borne (KE) de raccordement d'une terre de commande destinée à connecter la résistance (R_{aEKE}) de couplage de boucle à la borne de terre (PE),
**caractérisé par**
la superposition d'une tension d'excitation (U_{gEKE}) au moyen de la source (U_{gEKE}) de tension d'excitation,
la détection et le filtrage d'une tension (U_{mEKE}) de mesure de boucle au moyen du montage d'essai (12) et du circuit de filtrage (12),
l'évaluation de la tension (U_{mEKE}) de mesure de boucle et le calcul de la résistance de terre (R_{EKE}) au moyen du microcontrôleur (14).

8. Procédé de mesure selon la revendication 7,
**caractérisé en ce**
**qu'**un signal carré bipolaire dont la fréquence fondamentale est comprise entre 0,1 Hz et 10 Hz et dont la variation brusque de tension est inférieure à 10 V est superposé en tant que tension d'excitation (U_{gEKE}).

9. Procédé de mesure selon la revendication 8,
**caractérisé en ce que**
la variation brusque de tension de la tension d'excitation (U_{gEKE}) et la résistance (U_{mEKE}) de mesure de boucle dans le montage d'essai (12), le circuit filtrant (12) et le microcontrôleur (14) sont utilisées pour calculer la résistance de terre (R_{EKE}).
